Europäisches Patentamt

European Patent Office

Office européen des brevets

(11) Veröffentlichungsnummer: **0 040 844**
**B1**

(12) **EUROPÄISCHE PATENTSCHRIFT**

(45) Veröffentlichungstag der Patentschrift:
15.02.84

(21) Anmeldenummer: 81104011.2

(22) Anmeldetag: 25.05.81

(51) Int. Cl.³: **H 03 F 3/24,** H 03 F 3/217

(54) Steuerschaltung für induktiv belastete Röhren.

(30) Priorität: 28.05.80 AT 2827/80

(43) Veröffentlichungstag der Anmeldung:
02.12.81 Patentblatt 81/48

(45) Bekanntmachung des Hinweises auf die Patenterteilung:
15.02.84 Patentblatt 84/7

(84) Benannte Vertragsstaaten:
CH DE FR GB LI

(56) Entgegenhaltungen:
FR - A - 2 295 627
US - A - 3 643 161

(73) Patentinhaber: SIEMENS AKTIENGESELLSCHAFT,
Berlin und München Wittelsbacherplatz 2,
D-8000 München 2 (DE)

(72) Erfinder: Willer, Walter, Rottersdorf 23,
A-3124 Statzendorf (AT)
Erfinder: Fuchs, Peter, Dipl.-Ing., Praterstrasse 74,
A-1020 Wien (AT)
Erfinder: Riegler, Gerhard, Siebenbürgerstrasse 145,
A-1222 Wien (AT)

## Steuerschaltung für induktiv belastete Röhren

Die Erfindung betrifft eine Steuerschaltung zur Ansteuerung induktiv belasteter Röhren mit pulsdauermodulierten Signalen mittels eines Schaltverstärkers, der zwei gegensinnig gesteuerte elektronische Schalter enthält, von denen der eine die Durchschalte-Steuerspannung und der andere die Sperrspannung an das Gitter der Röhre legt.

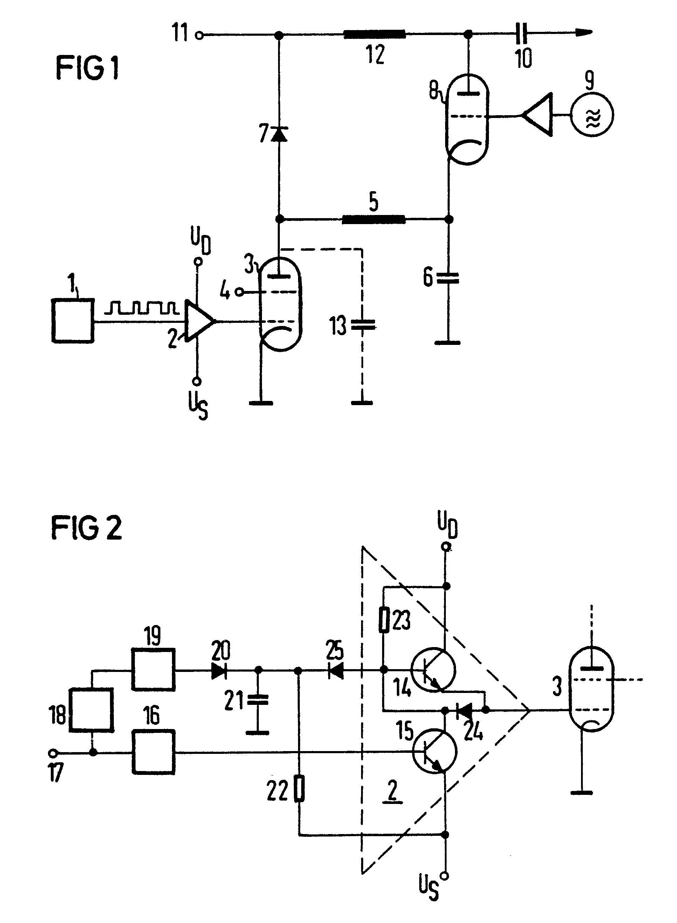

Steuerschaltungen dieser Art finden in Sendern üblicher Bauart mit einer Verstärkerstufe für pulsdauermodulierte Signale Verwendung. Zum besseren Verständnis der Erfindung ist in Fig. 1 der Zeichnung ein solcher Sender dargestellt und im folgenden beschrieben:

Aus dem zu übertragenden niederfrequenten Signal wird in einem Modulator 1 eine Serie von dauermodulierten Impulsen gewonnen, deren Tastverhältnis also dem jeweiligen Augenblickswert des niederfrequenten Signales entspricht. Diese dauermodulierten Impulse werden dem Eingang eines Schaltverstärkers 2 zugeführt, der während der Impulspausen eine Sperrspannung $U_S = -300$ V und während der Dauer der Impulse eine Durchschalte-Steuerspannung $U_D = +250$ V an das Steuergitter einer Tetrode 3 durchschaltet. Mit 4 ist der Anschluss für die Schirmgitterspannung von $+500$ V bezeichnet. Die Tetrode 3 liefert die am Steuergitter angelegten Impulse verstärkt an ein mit einer Spule 5 und einem Kondensator 6 angedeutetes Tiefpassfilter. Eine Freilaufdiode 7 entlädt die Spule 5, wenn die Tetrode 3 gesperrt ist. Das Tiefpassfilter 5, 6 unterdrückt die Schaltfrequenzen und lässt nur den niederfrequenten Anteil bzw. den Gleichspannungsanteil des Signales an die Kathode der Hochfrequenz-Senderöhre 8, welche von einem Steuersender 9 mit der Trägerfrequenz angesteuert wird. Über einen Ausgangskoppelkondensator 10 gelangt das amplitudenmodulierte HF-Signal an ein Anpassungsfilter. Der Speisepunkt der Betriebsspannung von $+17,5$ kV ist mit 11 bezeichnet. Eine Drossel 12 trennt das Hochfrequenzsignal von der Speisespannungsquelle.

In Fig. 1 ist weiters mit strichlierten Linien das Vorhandensein einer Kapazität 13 symbolisiert, die die Anode der Tetrode 3 gegenüber ihrer Umgebung aufweist und die zu einer speziellen Art von Verzerrungen des zu übertragenden niederfrequenten Signales Anlass gibt. Wenn die Tetrode 3 nach einem vorangegangenen Sperrzustand durchschaltet, so wird die Ladung der Anodenkapazität 13 bei gleichzeitiger Erzeugung von Verlustwärme vernichtet. Beim Sperren der Röhre wird die Anodenkapazität 13 von dem in der Spule 5 fliessenden Strom solange aufgeladen, bis ihre Spannung so hoch wird, dass die Freilaufdiode 7 leitend wird, worauf der Spulenstrom in das Netzgerät zurückfliesst. Zufolge der speziellen Schaltung fliesst der Entladestrom der Spule 5 auch über die HF-Senderöhre 8 und erzeugt an dieser einen höheren Spannungsabfall, als es dem zu modulierenden Tastverhältnis entspricht. Während der Abschalteflanke wird dadurch der Spulenstrom, der nach dem Sperren der Tetrode 3 über die Freilaufdiode 7 sofort abklingen sollte, sogar noch vergrössert, da die geglättete Spannung am Kondensator 6 grösser ist als die momentane Spannung an der Anodenkapazität 13. Wenn danach der Spulenstrom seine Polarität bereits gewechselt hat, wird das Abklingen des Stromes durch den Einfluss der Anodenkapazität 13 verlangsamt. Dieser Einfluss ist besonders bemerkbar bei geringem Tastverhältnis, weil dabei die Spannung am Kondensator 6 besonders hoch ist (d.h. die Spule 5 wird lange „überladen") und weil bei geringem Tastverhältnis der Spulenendstrom sehr klein ist und sich daher eine entsprechend schräge Flanke des Anodensignales einstellt. Dies wirkt sich beispielsweise auf die Übertragung eines niederfrequenten Sinussignales in der Weise aus, dass einerseits die Flanken der Sinuskurve etwas abgesenkt werden, während an der Stelle des Amplitudenmaximums eine zusätzliche zäpfchenartige Spitze in der Höhe von etwa 10% der Amplitude auftritt. Dieses „Zäpfchen" ist umso schmäler und umso steiler, je kürzer die Einschaltflanken sind. Die Höhe hängt nur von der Anodenkapazität 13 und vom Lastwiderstand der Senderöhre 8 ab.

Zur Kompensation der durch diesen Effekt bedingten Verzerrungen ist es bekannt, am Gitter der Tetrode 3 eine überlagerte Niederfrequenz-Amplitudenmodulation anzuwenden, um eine entsprechende Neigung der Einschaltflanke hervorzurufen. Eine feststehende Neigung der Einschaltflanke zwecks Entzerrung bringt jedoch einen grossen Wirkungsgradverlust sowie Verzerrungen im Bereich grosser Tastverhältnisse, die sodann bei der Aufbereitung der pulsdauermodulierten Signale kompensiert werden müssen, was eine Reduktion des Wirkungsgrades von 95% auf 80% bewirkt. Es ist vielmehr notwendig, die Neigung der Einschaltflanken immer der Neigung der durch den jeweiligen Spulenstrom sich ergebenden Ausschalteflanken anzupassen. Dann ist das Anodensignal immer ein Trapez bzw. ein Dreieck, das den gleichen Flächeninhalt und damit Leistungsinhalt darstellt wie das ideale Rechteck.

Die Erfindung hat sich die Aufgabe gestellt, eine Steuerschaltung für induktiv belastete Röhren zu schaffen, die Signalverzerrungen aus den oben angeführten Gründen vermeidet und erzielt dies dadurch, dass an die Steuerelektrode des für das Anlegen der Durchschalte-Steuerspannung vorgesehenen elektronischen Schalters ein die Geschwindigkeit des Spannungsanstieges an der Steuerelektrode nach dem Erreichen einer Schwellspannung vermindernder Kondensator mittels einer mit einer Überlaufstromschalteinrichtung zusammenwirkenden Diode anschaltbar ist, wobei die Schwellspannung eine insbesondere lineare Funktion des jeweiligen zeitlichen Mittelwertes der pulsdauermodulierten Signale ist. Die Überlaufstromschalteinrichtung besteht gemäss einem weiteren Merkmal der Erfindung aus einem von den pulsdauermodulierten Signalen beaufschlagten Tiefpassfilter, einem nachgeschalteten Verstärker und einer an dessen Ausgang angeschlossenen Diode, die an die Verbindungsstelle zwischen dem Kondensator und der mit der Steuerelektrode verbundenen Diode angeschlossen ist.

Ein Ausführungsbeispiel der Erfindung ist in Fig. 2 der Zeichnung dargestellt. Hier ist der dem Steuergitter der Tetrode 3 vorgeschaltete Schaltverstärker 2 (strichliert angedeutet) mit seinen Bestandteilen dargestellt. Dazu gehören im wesentlichen als elektronische Schalter wirkende Transistoren 14, 15, die in Abhängigkeit von pulsdauermodulierten Signalen aus einem Verstärker 16 gegensinnig auf- und zugesteuert werden. Hierbei legt der Transistor 14 im leitenden Zustand die Durchschalte-Steuerspannung $U_D$ an das Steuergitter der Tetrode 3, während der Transistor 15 zur Anschaltung der Steuergitter-Sperrspannung $U_S$ dient. Die unverstärkten pulsdauermodulierten Signale werden über den Eingang 17 einerseits dem Verstärker 16 und anderseits über ein demodulierendes Filter 18 einem Gleichspannungsverstärker 19 zugeführt, dessen Ausgangsspannung über eine Diode 20 an einen Kondensator 21 angelegt ist. Der mit einem Anschluss geerdete Kondensator 21 liegt mit seinem zweiten Anschluss über einen Widerstand 22 am Sperrpotential $U_S$. Zwischen Kollektor und Basis des Transistors 14 ist ein Widerstand 23 und zwischen der Basis und dem Emitter ist eine Diode 24 geschaltet. Schliesslich ist die Basis des Transistors 14 über eine Diode 25 an die Verbindungsstelle der Diode 20 mit dem Kondensator 21 angeschlossen.

Die Wirkungsweise der erfindungsgemässen Steuerschaltung beruht darauf, dass die den jeweiligen Momentanwert des niederfrequenten Signales abbildende Ausgangsspannung des Gleichspannungsverstärkers 19, der über die Diode 20 einen Überlaufstromschaltkreis speist, am Kondensator 21 liegende Schwellspannung für die mit dem Überlaufstromschaltkreis zusammenwirkende Diode 25 bildet. Wenn die an der Basis des Transistors 14 liegende Transistor-Steuerspannung die am Kondensator 21 liegende Schwellspannung überschreitet, wird die Diode 25 leitend, wodurch ein Stromfluss aus der Spannungsquelle der Durchschalte-Steuerspannung $U_D$ über den Widerstand 23, die Diode 25 zum Kondensator 21 zustande kommt, solange, bis der Kondensator 21 auf den Spannungswert $U_D$ aufgeladen ist. Während dieser Aufladung verlaufen die Flanken der Impulse der Durchschalte-Steuerspannung $U_D$ am Steuergitter der Tetrode 3 (vom Erreichen des vom jeweiligen Signalwert abhängigen Wertes der Schwellspannung an) abgeschrägt solange, bis der Kondensator 21 auf den Wert $U_D$ aufgeladen ist. Die Tetrode 3 wird bis zum jeweiligen, dem Tastverhältnis und der Induktivität der Spule 5 entsprechenden Wert des in der Spule noch fliessenden Stromes aufgesteuert, bis sie in der Stromführung die Freilaufdiode 7 ablöst. Wenn der Wert der am Kondensator 21 liegenden Schwellspannung erreicht wird, schaltet die Tetrode 3 im Bereich der schrägen Flanke durch bis zum Restspannungswert. Beim Abschalten ist der Transistor 14 wieder über die Diode 25 entkoppelt und der Kondensator 21 entlädt sich über den Widerstand 22 um, bis auf den durch den Gleichspannungsverstärker 19 eingestellten Anfangswert, der über die Diode 20 aufrecht erhalten wird.

Beim nächsten Schaltvorgang ist der Anfangswert wieder nur vom momentanen Tastverhältnis abhängig. Durch geeignete Wahl des Schwellwertes mit Hilfe entsprechender Wahl der Entzerrerkurve des Gleichspannungsverstärkers 19 und entsprechender Einstellung der Dauer der Flankenabschrägung durch die Bemessung des Kondensators 21 und des Widerstandes 23 kann der Einfluss der Anodenkapazität genau kompensiert werden. Hierbei wird der Schwellwert der Spannung durch die Belastung durch die Hochfrequenz-Röhre 8 und durch die Induktivität der Spule 5 bestimmt, während die Flankenneigung auf die Anodenkapazität der Tetrode 3 und die Induktivität der Spule 5 abgestimmt werden muss. Die Erfindung bietet damit die Möglichkeit, bei grossem Tastverhältnis über einen entsprechenden Schwellwert sehr steile Flanken beim Einschaltsignal (die notwendig sind, da auch die Ausschaltflanken infolge des grossen Spulenstromes sehr steil sind) einzustellen. Bei kleinem Tastverhältnis ergibt sich infolge des geringeren Spulenstromes und der hohen Aufladung des Kondensators 6 entsprechend der mehr abgeschrägten Ausschalteflanke auch eine entsprechend abgeschrägte Einschalteflanke. Es lässt sich damit eine wirksame Reduzierung des durch die Anodenkapazität 13 bedingten Klirrfaktors sowie ein hoher Wirkungsgrad der Tetrode 3 erzielen.

**Patentansprüche**

1. Steuerschaltung zur Ansteuerung induktiv belasteter Röhren mit pulsdauermodulierten Signalen mittels eines Schaltverstärkers (2), der zwei gegensinnig gesteuerte elektronische Schalter (14, 15) enthält, von denen der eine (14) die Durchschalte-Steuerspannung und der andere (15) die Sperrspannung an das Gitter der Röhre (3) legt, dadurch gekennzeichnet, dass an die Steuerelektrode des für das Anlegen der Durchschalte-Steuerspannung vorgesehenen elektronischen Schalters (14) ein die Geschwindigkeit des Spannungsanstieges an der Steuerelektrode nach dem Erreichen einer Schwellspannung vermindernder Kondensator (21) mittels einer mit einer Überlaufstromschalteinrichtung (19, 20) zusammenwirkenden Diode (25) angeschaltet ist, wobei die Schwellspannung eine insbesondere lineare Funktion des jeweiligen zeitlichen Mittelwertes der pulsdauermodulierten Signale ist.

2. Steuerschaltung nach Anspruch 1, dadurch gekennzeichnet, dass die Überlaufstromschalteinrichtung aus einem von den pulsdauermodulierten Signalen beaufschlagten Tiefpassfilter (18), einem nachgeschalteten Gleichstromverstärker (19) und einer an dessen Ausgang angeschlossenen Diode (20) besteht, die an die Verbindungsstelle zwischen dem Kondensator (21) und der mit der Steuerelektrode verbundenen Diode angeschlossen ist.

## Claims

1. A control circuit for operating inductively loaded tubes by means of pulse-duration-modulated signals via an amplifier (2) which includes two oppositely controlled electronic switches (14, 15), one (14) of which connects the switch-through control voltage and the other (15) connects the blocking voltage to the grid of the tube (3), characterised in that by means of a diode (25) which interacts with an overflow current switching device (19, 20), a capacitor (21) is connected to the control electrode of the electronic switch (14) provided for the connection of the switch-through control voltage to reduce the rate of the voltage rise in the control electrode when a threshold voltage has been reached, the threshold voltage being a particularly linear function of the respective mean value in terms of time of the pulse-duration-modulated signals.

2. A control circuit as claimed in claim 1, characterised in that the overflow current switching device consists of a low-pass filter (18) triggered by the pulse-duration-modulated signals, a following direct current amplifier (19) and a diode (20) connected to the output of said d.c. amplifier and to the junction between the capacitor (21) and the diode coupled to the control electrode.

## Revendications

1. Circuit de commande pour la commande de tubes chargés inductivement par des signaux impulsionnels modulés en durée au moyen d'un amplificateur de commutation (2), qui comporte deux commutateurs électroniques (14, 15) commandés en opposition dont l'un (14) applique la tension de commande de mise dans l'état passant et dont l'autre (15) applique la tension de blocage à la grille du tube (3), caractérisé par le fait qu'un condensateur (21) qui réduit la vitesse de la montée de tension sur l'électrode de commande une fois qu'une valeur de seuil est atteinte est relié à l'électrode de commande du commutateur électronique (14) prévu pour l'application de la tension de commande de mise dans l'état passant, au moyen d'une diode (25) qui coopère avec un dispositif de commutation du courant en excès (19, 20), la tension de seuil étant une fonction sensiblement linéaire de la valeur moyenne respective dans le temps des signaux impulsionnels modulés en durée.

2. Circuit de commande suivant la revendication 1, caractérisé par le fait que le dispositif de commutation du courant en excès est constitué par un filtre passe-bas (18) recevant les signaux d'impulsions modulés en durée, un amplificateur de courant continu (19) monté en aval, et une diode (20) reliée à sa sortie, qui est raccordée au point de jonction entre le condensateur (21) et la diode reliée à l'électrode de commande.

FIG 1

FIG 2